# EUROPEAN PATENT SPECIFICATION

(11) **EP 2 679 538 B1**
(45) Date of publication and mention of the grant of the patent: **08.04.2015**
(21) Application number: 12173430.5
(22) Date of filing: 25.06.2012
(51) Int. Cl.: C01B 19/00, C30B 29/48, C30B 29/60, B82Y 30/00, C30B 7/00, C30B 7/14, A61N 5/06, B82Y 40/00

(54) **Method for the preparation of single sized II-VI semiconductor nanocrystals**
Verfahren zur Herstellung von einzeln bemessen II-VI-Halbleiter-Nanokristalle
Procédé pour la préparation des nanocristaux II-VI à taille unique

(43) Date of publication of application: 01.01.2014
(73) Proprietor: King Saud University, 11421 Riyadh (SA)
(72) Inventor: Rezaul Karim, Mohammed, 11421 Riyadh (SA); Badruz Zaman, Mohammed, 11421 Riyadh (SA); Al-Ahmari, Abdurahman, 11421 Riyadh (SA)
(74) Representative: Goddar, Heinz J.

(56) References cited:
- WO-A1-2009/045177
- WO-A1-2009/120688
- KUI YU ET AL: "Thermodynamic Equilibrium-Driven Formation of Single-Sized Nanocrystals: Reaction Media Tuning CdSe Magic-Sized versus Regular Quantum Dots", JOURNAL OF PHYSICAL CHEMISTRY C, vol. 114, no. 8, 4 March 2010 (2010-03-04) , pages 3329-3339, XP55035902, ISSN: 1932-7447, DOI: 10.1021/jp909310a
- JIANYING OUYANG ET AL: "Multiple Families of Magic-Sized CdSe Nanocrystals with Strong Bandgap Photoluminescence via Noninjection One-Pot Syntheses", JOURNAL OF PHYSICAL CHEMISTRY C, vol. 112, no. 36, 11 September 2008 (2008-09-11), pages 13805-13811, XP55035817, ISSN: 1932-7447, DOI: 10.1021/jp803845n
- S. KUDERA ET AL: "Sequential Growth of Magic-Size CdSe Nanocrystals", ADVANCED MATERIALS, vol. 19, no. 4, 19 February 2007 (2007-02-19), pages 548-552, XP55035815, ISSN: 0935-9648, DOI: 10.1002/adma.200601015
- KUI YU ET AL: "Single-Sized CdSe Nanocrystals with Bandgap Photoemission via a Noninjection One-Pot Approach", JOURNAL OF PHYSICAL CHEMISTRY C, vol. 113, no. 9, 5 March 2009 (2009-03-05) , pages 3390-3401, XP55035818, ISSN: 1932-7447, DOI: 10.1021/jp809990a

## Description

The present invention relates to a method for the preparation of single-size II-VI nanocrystals.

Photoluminescent colloidal semiconductor nanocrystals (Quantum dots, QDs) are of great interest for both fundamental and apply-oriented research due to their numerous potential applications in biomedical engineering and thin-film devices. Various solution-based synthetic routes to photoluminescent CdSe QDs have been developed. CdSe QDs within a size range of 2 - 7 nm exhibit photoemission from blue (ca. 470 nm) to red (ca. 640 nm), with a full width at half maximum (FWHM) in the range from 25-40 nm. Regular QDs (RQDs) have a certain size distribution due to the nanocrystals having various numbers of atoms. These nanocrystals have structural irregularity at the atomic level. However, cluster materials possess controllable assembly of their structure and chemical ordering on both the molecular and nanoscale, with particular atomic arrangements. The largest CdSe cluster molecule studied overlaps in size with the smallest CdSe QDs.

Therefore, it is very important to study the CdX (X = S, Se, and Te) single-sized, also called magic-sized, cluster or nanocrystals which have high photoluminescence efficiencies.

CdSe compounds are of interest due to their bulk band gap (Eg = 1.7 eV), which is much smaller than the transition energy of their capping ligands. Thus, a large range of energetic shift is possible, prior to mixing between the "band gap" transition and the intra-ligand transition, when the size decreases. Therefore, the study of nanometer sized crystallites, particularly "magic-sized" quantum dots (MSQDs), provides an excellent opportunity to investigate the evolution of material properties from molecules to bulk.

Recently, magic-sized CdSe nanoclusters, have been synthesized. Single-sized structures can be achieved since there is a handful of clusters, consisting of a few tens or hundreds of atoms, having an exceptional high stability. This "magic" structures are formed by closed shells of atoms. For example, different families of almost monodisperse CdSe clusters of sizes down to 1.3 nm are known.

However, the synthesis of such single-sized semiconductor CdSe nanoclusters remains a challenging problem. One major difficulty is to establish a suitable synthetic route that yields CdSe MSQDs having band-gap photoemission (Kudera et al. Adv. Mater. 2007, 19, 548-552). Most of the work until now has focused on the composition and structure of CdSe clusters, sheets and ribbons. There are only limited studies of the band-gap photoluminescent emission of CdSe MSQDs with full width half maximum (FWHM) of ~ 10 nm and quantum yield (QY) ≤ 5% in toluene (Yu et al. J. Phys. Chem. C 2009, 113(9), 3390-2401; Ouyang et al. J. Phys. Chem. C. 2008,112,13805-13811).

Another difficulty is to determine the optimal synthetic parameters and reaction media which reliably produce a designated species of the CdSe MSQDs and not a mixture of various species. For example, based on a low temperature Se-injection synthetic approach of Kudera et al. Adv. Mater. 2007, 19, 548-552, a series of MSQDs families with mostly shorter wavelength in UV-vis absorptions have been reported.

Yu et al. J. Phys. Chem. C, 2010, 114, 3329-3339 describes thermodynamic equilibrium-driven formation of single-sized nanocrystals: reaction media tuning CdSe magic-sized versus regular quantum dots.

WO 2009/120688 A1 discloses magic size nanoclusters comprising lead and one or more chalcogens. The described nanoclusters feature both spectrally narrow fluorescence and high quantum efficiencies. Further disclosed is a method for the preparation of the nanoclusters.

Yu et al. J. Phys. Chem. C., 2009, 113, 3390-3401 discloses single-sized CdSe nanocrystals with bandgap photoemission via a noninjection one-pot approach.

WO 2009/045177 A1 discloses a method for forming a nanocrystal. The prepared nanocrystal is described to be a binary nanocrystal comprising a metal and a group V or VI element.

Accordingly, it is an object of the present invention to provide a method for preparing single-sized II-VI semiconductor nanocrystals which overcomes the drawbacks of the prior art. In particular, a method shall be provided allowing the preparation of single-sized II-VI semiconductor nanocrystals of improved full with half maximum (FWHM) and quantum yield (QY) of the band-gap photoluminescent emission.

This objective is achieved by a method according to the independent claim. Preferred embodiments result from the subclaims.

In particular, this object is achieved by a method for preparing single-sized II-VI semiconductor nanocrystals comprising the steps:
a) providing a first solution which comprises at least one group II B element precursor, at least one carboxylic acid and at least one alkene;
b) providing a second solution which comprises at least one group VI A element precursor and at least one secondary phosphine;
c) mixing the first solution and the second solution to obtain a reaction mixture; and
d) heating the reaction mixture to obtain a solution containing the single-sized II-VI semiconductor nanocrystals,
wherein the carboxylic acid: group II B element precursor molar ratio is 3 or less, preferably 2 or less; and
the group II B element precursor: group VI A element precursor molar ratio has to exceed 2, preferably at least 4.

In a preferred embodiment, the group II B element and the group II B element precursor is Cd.

The group II B element precursor is an group II B element oxide.

Preferably, the carboxylic acid is an alkyl carboxylic acid, preferably a fatty acid.

In a preferred embodiment, the alkene is an C₆-C₁₂ alkene, most preferably 1-octene.

Further preferred, the group VI A element precursor is a group VI A element, preferably a group VI A element powder.

The group VI A element precursor is selenium.

It is further preferred that the secondary phosphine is an secondary aryl phosphine, most preferably diphenyl phosphine.

Even preferred, the second solution of step b) additionally comprises a solvent, preferably a solvent having a boiling point higher than 100°C.

Preferably, mixing in step c) is carried out under heating to a temperature up to 50°C.

In a further preferred embodiment, the method comprises an additional clean up step d') succeeding step d), preferably the additional clean up step d') succeeding step d), but before step e), comprises the substeps (i) cooling the solution containing the single-sized II-VI semiconductor nanocrystals to room temperature, (ii) precipitating the single-sized II-VI semiconductor nanocrystals by addition of a solvent or a solvent mixture which decreases the solubility of the single-sized II-VI semiconductor nanocrystals in the solution containing the single-sized II-VI semiconductor nanocrystals, (iii) centrifugation and (iv) decantation, wherein the steps (ii) to (iv) can be repeated several times.

It can be further preferred that the group VI A element precursor concentration in the mixture of the first solution and the second solution is in a range from 1 mmol/kg to 100 mmol/kg, preferably 10 mmol/kg to 70 mmol/kg based on the total weight of the second solution.

Preferably, the group VI A element precursor: secondary phosphine molar ratio is in a range from 1:4 to 1:2, most preferably is 1:1.

Described herein are single-size II-VI semiconductor nanocrystals prepared by the inventive method.

Further described herein are single-sized II-IV semiconductor nanocrystals for use and clinical light therapy applications.

Surprisingly, it was found that the inventive method, in particular the use of a secondary phosphine as reducing agent, provides the possibility to prepare single-sized II-VI semiconductor nanocrystals having a band-gap photoluminescent emission with improved FWHM and QY compared to the respective nanocrystals known in the prior art. It was further surprisingly found that the inventive method allows the preparation of high quality nanocrystals in high yields having a high storage stability by using a non injection-based one-pot approach at comperatively low temperatures.

The term "single-sized" as used in the present application relates to particles or crystals having substantially the same size due to their closed shell atom structure. The term "single-sized" is synonymous with the term "magic-size" as often used in the prior art.

A "II-VI semiconductor" in terms of the present invention is a semiconductor material essentially formed by one element of the group II B of the periodic table of elements, namely zinc, cadmium or mercury, and one element of the group VI A of the periodic table of elements, namely oxygen, sulphur, selenium or tellurium. In the same way, materials comprising more than one elements of each group are conceivable.

Nanocrystals in terms of the present application are crystals each having a size, in a range from one to several hundreds nanometers, e.g. 500, 700 or 1000 µm, in at least one preferably in all three directions in space.

Preferably, the present application relates to CdSe single-sized nanocrystals, More preferably, the present invention relates to single-sized CdSe nanocrystals of the so called 463 family. By the term "463 family", a particularly stable, "magic" structure of CdSe nanocrystals is designated, having a maximum absorption band at 463 nm, a twin absorption band at 436 nm and a band-gap emission band at 465 nm. CdSe single-size nanocrystals of the 463 family have a size of about 2 nm.

Preferably, heating in step d) is heating the reaction mixture to a temperature in a range from 80-280°C, preferably 120-240°C. Even preferred, heating is conducted by applying a temperature gradient.

"Fatty acids" are non branched alkyl chain carboxylic acids having 6 to 28 carbon atoms.

Preferably selenium powder used as a group VI A element precursor has a particle size of about 100 mesh.

Even preferred, the solvent which can be comprised in the second solution in a preferred embodiment is a high boiling organic solvent having a boiling point of more than 100°C, for example toluene, mesitylene, chlorobenzene etc.

Room temperature will be understood by a person skilled in the art to be a temperature of about 18 to about 25°C.

The invention will now be described in more detail by the examples with reference to the accompanying drawings with the intention to exemplify the invention. The examples, however, are not intended to have any limiting effect on the subject matter of the claims or on the scope of protection.

Fig. 1 shows an absorption spectra of CdSe single-sized nanocrystals prepared by the inventive method (dashed line) and a band-gap photoluminescent emission spectra of CdSe single-sized nanocrystals prepared by using the inventive method.

Fig. 2 shows absorption spectra of CdSe single-sized nanocrystals prepared by using different amounts of carboxylic acid (MA).

Fig. 3 shows absorption spectra of CdSe single-sized nanocrystals prepared by using different ratios of Cd:Se of 2:1, 4:1 and 6:1.

Fig. 4 shows absorption spectra of CdSe single-sized nanocrystals prepared by using different amounts of selenium powder in the second solution, wherein the molar amount of selenium refers to a total amount of 1 kg of the second solution.

Fig. 5 shows absorption spectra of CdSe single-sized nanocrystals prepared by using different molar ratios of selenium:diphenyl phosphine (DPP) of 1:1 and 1:4.

Fig. 6 shows absorption spectra of CdSe single-sized nanocrystals prepared by using the inventive method (98% DPP) and by using tertiary phosphines (n-trioctyl phosphine (TOP) and n-tributly phosphine (TBP)) of different purities instead of DPP, wherein the approaches using TOP and TPP serve as comparative examples.

### Examples

*Materials.* All chemicals used are commercial available and were used as received. Cadmium acetate dihydrate (Cd(OAc)₂·2H₂O was from Alfa Aeser. All the other chemicals were purchased from Sigma-Aldrich. Selenium powder (-100 mesh, purity 99.9%), Myristic acid (MA, 99.5%), 1-Octadecene (ODE, tech. 90%), three phosphines: trioctylphosphine (TOP, tech. 90% and purity 97%), tributylphosphine (TBP, purity 97% and 99%), and Di-phenlyphosphine (DPP, 98%).

### Example 1

### Typical Synthesis of CdSe MSQDs.

First, two stock solutions (Cd and Se) were prepared.

A typical *Cd-stock solution* was prepared by mixing CdO (77.04 mg, 0.6 mmol), MA (91.35 mg, 0,4 mmol), and ODE (4.9 g) which were loaded in a 50 mL three-neck reaction flask at room temperature. After degassing, the mixture was heated to 160°C with stirring under inert atmosphere for one hour to form a precursor of cadmium myristate (Cd(MA)₂), subsequently cooled to ambient temperature and stored under inert atmosphere.

For the *Se-stock solution,* elemental Se (11.84 mg, 0.15 mmol) was heated with DDP (27.92 mg, 0.15 mmol, 26 µl) to make a clear solution which solidifies at room temperature. This solid was dissolved in Toluene to make a 0.1 M solution of Se/DPP in 1.5 ml Toluene and kept in Glove Box.

The Cd-stock solution was transferred to a three-necked round bottom flask and degassed under vacuum from 50°C to 120°C for 2 hrs. Afterwards, the reaction mixture was cooled to 50°C and a stoichiometric amount of Se-stock solution was added. This mixture was heated up at a constant rate of 10°C/minute, degassed, stirred and heated to 120 °C for one hour. Afterwards, the temperature was either kept at a constant temperature for a certain growth period or increased slowly to 240°C under a flow of argon and subsequently quenched to ambient temperature.

Afterward, 30 µL of sample was dispersed into 3 mL toluene for measurement of the optical properties of the prepared CdSe MSQDs.

Absorption spectra were collected on UV-3600 UV/Vis/NIR spectrometer (Shimadzu, Japan) using a 1-nm data collection interval and scan rate of 600nm/min. Photoemission experiments were performed on a RF-5301PC spectrometer (Shimadzu, Japan), with a 450 W Xe lamp as the excitation source, an excitation wavelength of 500 nm (if not specified), an increment of data collection of 2 nm, and the slits for excitation and emission of 3 nm.

If necessary, aliquots were purified by precipitation twice in toluene/methanol; afterward, the purified powders were dispersed in toluene with a proper concentration.

***Purification Procedure**.* 30 ml of a mixture of toluene and methanol (1:1) was added to the synthesized CdSe MSQDs to precipitate the nanoparticles. After centrifugation (4000rpm for 10 minutes), the supernatant was decanted and toluene was added to disperse the CdSe MSQDs under shaking. Such a process of the purification was carried out for 3~5 times, gradually reducing to the amount of solvent until finally 7/8 ml of each solvent were used, to obtain a solid powder materialized.

For transmission electron microscopy (TEM) characterization, a purified sample stored in toluene was deposited on a carbon-coated copper grid and was studied on a JEM-2100F (JEOL, Japan) electron microscope operating at 200 kV and equipped with a Gatan UltraScan 1000 CCD camera.

Powder X-ray diffraction (XRD) patterns were recorded at room temperature on a XRD-7000 (Shimadzu, Japan) X-ray diffractometer using Cu Kα radiation in a θ - θ mode. The generator was operated at 40 kV and 40 mA, and data were collected between 5° and 80° in 2θ with a step size of 0.1° and a counting time of 5 s per step. XRD samples were prepared by depositing the purified nanoparticles on low-background quartz plates.

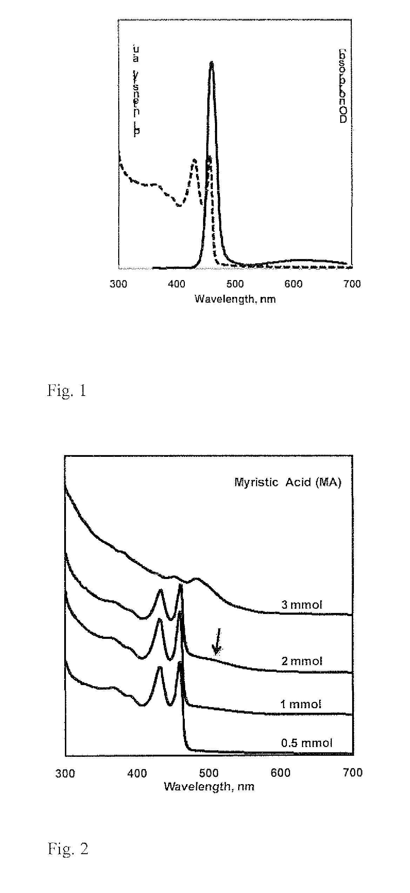

As it can be taken from the absorption and photoluminescence spectra shown in Figure 1, single-sized CdSe nanocrystals were prepared having extraordinary high quantum yields (QY) of 26 % while simultaneously having a FWHM of only 10 nm. The obtained yield of nanocrystals was 2500 µmol/l for single-sized CdSe 463 family nanocrystals.

### Example 2

*Effect of Myristic acid (MA) : Cd molar ratio:* Figure 2 shows the temporal evolution of the absorption spectra of the MSQDs from four synthetic batches with the different feed molar ratio of xMA-to-1Cd (x = 0.5, 1.0, 2.0, 3.0) by fixing the growth temperature at 200°C, feed molar ratios of Cd : Se = 4 : 1, neat Se : DPP =1:1 and a total concentration of Se = 30 of mmol/kg. The growth temperature from 180°C to 220°C for each batch of reaction was also examined. When the MA : Cd feed molar ratios was larger than two, only regular QDs of a wide size distribution were synthesized. Thus, the present study only deals with the MA to Cd feed molar ratios not larger than two. There were little regular QDs observed with the 2 MA to 1 Cd mmol feed molar ratios. Moreover, when the reaction temperature increased above 240°C, regular CdSe QDs were formed. CdSe-463 MSQDs exhibited much a narrower band gap PL emission than the regular QDs.

### Example 3

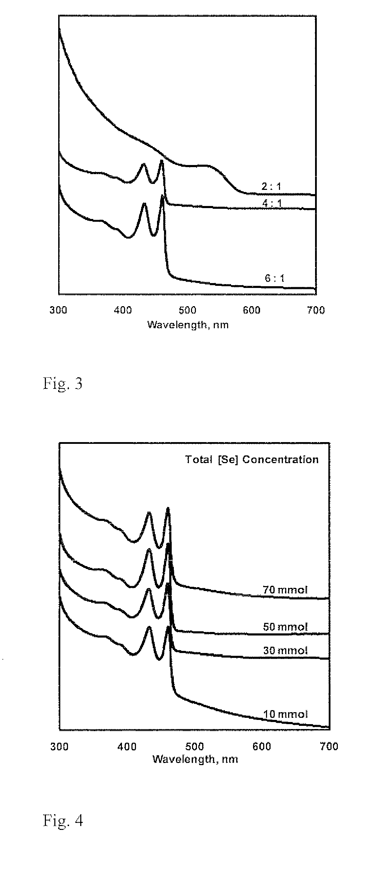

*Effect of Cd: Se molar ratio:* With a fixed molar ratio of 1 mmol myristic acid to 1 mmol of Cd feed, the influence of the molar ratio Cd : Se on the CdSe-463 MSQDs formation was investigated. Figure 3 shows the temporal evolution of the absorption spectra from three synthetic batches with the different Cd : Se feed molar ratios of (i) Cd : Se = 2 : 1, (ii) Cd : Se = 4 : 1 and (iii) Cd : Se = 6 : 1. In each synthetic batch, the growth temperature was fixed at 200°C, growth period 60 min, feed molar ratio of neat Se : DPP = 1 : 1 and total concentration of Se = 30 mmol/kg. The existence of CdSe-463 MSQDs was significant from batches (ii) Cd : Se = 4 : 1 and (iii) Cd : Se = 6 : 1, whereas regular CdSe QDs were observed from the molar ratios of Cd : Se = 2 : 1. The continuous red-shift of the absorption peak positions was examined for the Cd : Se = 2 : 1 molar ratios during the increase of the reaction temperature from 240 to 260°C and the growth period. When the Cd : Se feed molar ratio was further increased to 8 : 1 (data not shown), the thermal stability of CdSe-463 MSQDs increased at 240°C, together with much more inhibition of the presence of regular QDs. Therefore, large Cd : Se feed molar ratios favor the formation of CdSe-463 MSQDs with enhanced thermal stability during synthesis, while restraining the formation of regular QDs.

### Example 4

*Effect of [Se] feed concentration:* To understand the total influence of the ingredients of the reaction mixture, feed Se concentration was applied in our reaction scheme. We performed four batches of reactions with different Se feed concentrations of 10, 30, 50 and 70 mmol/kg (Figure 4). The two absorption peaks 448 nm and 461 nm were readily monitored and resulting CdSe-463 MSQDs were identical whereas calculated photoluminescence QY and particle yield were verified for the four different concentrations. Typical photoluminescence QY and particle yields are summarized in Table 1.

**Table 1. Quantum yields (QY) and particle yields.**

| | 10 mmol/Kg | 30 mmol/Kg | 50 mmol/Kg | 70 mmol/Kg |
|---|---|---|---|---|
| QY,% | 10 | 20 | 12 | 7 |
| Particles Yield, µmol/L | 1300 | 1600 | 2000 | 1700 |

### Example 5

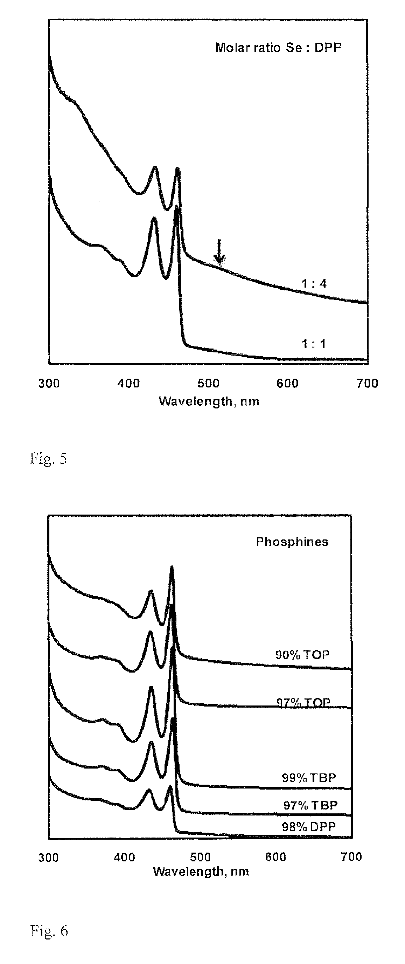

*Effect of Se . DPP molar ratio:* The DPP influence on the quality of the CdSe-463 MSQDs was also investigated. In all the reactions mentioned above DPP : Se = 1 : 1 were added. Addition of DPP as DPP/Se solution produced the highest QY of 26%. In an effort to further improve the QY, the amount of DPP was increased up to a 4 : 1 molar ratio of DPP : Se. However, the QY decreased to 0.5% and regular CdSe QDs were observed in the optical spectra (Figure 5). Moreover, the presence of additional or free DPP in the reaction system again decreased the QY and regular QDs were generated from the 6 mmol of DPP in the reaction system.

### Comparative Examples

In the prior art, most approaches for preparing CdSe nanocrystals disclose the use of either trioctyl phosphine (TOP) or tributyl phosphine (TBP). Based on the model reaction parameters using MA : Cd (1 : 1), Cd : Se (4 : 1) and DPP : Se (1 :1) in 1-octadecene at (180-220°C), the effect of the use of commercially available TOP (90% and 97%) and TBP (97% and 99%), on the formation of the CdSe-463 MSQDs was explored (Figure 6). In the reaction flask, TOPSe made from TOP 90% exhibited higher reactivity than that made from TOP 97%. The reactivity of TBPSe made from TBP 97% and TBP 99% showed the same trend. The stock of DPPSe demonstrated the highest reactivity among the phosphines used in the reaction system. Typical photoluminescence QY and particle yield for three phosphines and their purity are summarized in Table 2.

**Table 2. Calculated quantum yield (QY) and particle yield.**

| | TOP, 90% | TOP, 97% | TBP, 97% | TBP, 99% | DPP, 98% |
|---|---|---|---|---|---|
| QY, % | 2 | 8 | 4 | 4 | 20 |
| Particles Yield, µmol/L | 2300 | 1200 | 2200 | 2300 | 1600 |

The features disclosed in the foregoing description, in the claims and in the drawings may, both separately and in any combination thereof, be material for realizing the invention in diverse forms thereof.

## Claims

1. Method for preparing single-sized II-VI semiconductor nanocrystals comprising the steps:
a) providing a first solution which comprises at least one group II B element precursor, at least one carboxylic acid and at least one alkene;
b) providing a second solution which comprises at least one group VI A element precursor and at least one secondary phosphine;
c) mixing the first solution and the second solution to obtain a reaction mixture; and
d) heating the reaction mixture to obtain a solution containing the single-sized II-VI semiconductor nanocrystals;
wherein the carboxylic acid: group II B element precursor molar ratio is 3 or less, preferably 2 or less;
the group II B element precursor: group VI A element precursor molar ratio has to exceed 2, preferably at least 4,
the group VI A element precursor is selenium, and
the group II B element precursor is an group II B element oxide.

2. Method according to claim 1, wherein the carboxylic acid is an alkyl carboxylic acid, preferably a fatty acid.

3. Method according to any of preceding claims, wherein the alkene is a C₆-C₁₂ alkene, most preferably 1-octene.

4. Method according to any of the preceding claims, wherein the group VI A element precursor is a group VI A element, preferably a group VI A element powder.

5. Method according to any of the preceding claims, wherein the secondary phosphine is an secondary aryl phosphine, most preferably diphenyl phosphine.

6. Method according to any of the preceding claims, wherein the second solution of step b) additionally comprises a solvent, preferably a solvent having a boiling point higher than 100°C.

7. Method according to any of the preceding claims, wherein mixing in step c) is carried out under heating to a temperature up to 50°C.

8. Method according to any of the preceding claims, wherein the method comprises an additional clean up step d') succeeding step d), but before step e), preferably the additional clean up step d') succeeding step d) comprises the substeps (i) cooling the solution containing the single-sized 11-VI semiconductor nanocrystals to room temperature, (ii) precipitating the single-sized II-VI semiconductor nanocrystals by addition of a solvent or a solvent mixture which decreases the solubility of the single-sized II-VI semiconductor nanocrystals in the solution containing the single-sized II-VI semiconductor nanocrystals, (iii) centrifugation and (iv) decantation, wherein the steps (ii) to (iv) can be repeated several times.

9. Method according to any of the preceding claims, wherein the group VI A element precursor concentration in the mixture of the first solution and the second solution is in a range from 1 mmol/kg to 100 mmol/kg, preferably 10 mmol/kg to 70 mmol/kg based on the total weight of the second solution.

10. Method according to any of the preceding claims, wherein the group VI A element precursor: secondary phosphine molar ratio is in a range from 1:4 to 1:2, most preferably is 1:1.

## Patentansprüche

1. Verfahren zur Herstellung von II-VI-Halbleiternanokristallen einheitlicher Größe, umfassend die Schritte:
a) Bereitstellen einer ersten Lösung, die zumindest einen Vorläufer eines Elements der Gruppe II B, zumindest eine Carboxylsäure und zumindest ein Alken umfasst;
b) Bereitstellen einer zweiten Lösung, die zumindest einen Vorläufer eines Elements der Gruppe II A und zumindest ein sekundäres Phosphin umfasst;
c) Mischen der ersten Lösung und der zweiten Lösung, um ein Reaktionsgemisch zu erhalten; und
d) Erhitzen des Reaktionsgemisches, um eine Lösung zu erhalten, die die II-VI-Halbleiternanokristalle einheitlicher Größe enthält;
wobei das molare Verhältnis der Carboxylsäure zu dem Vorläufer des Elements der Gruppe II B 3 oder weniger ist, vorzugsweise 2 oder weniger;
das molare Verhältnis des Vorläufers des Elements der Gruppe II B zu dem Vorläufer des Gruppe VI A-elements 2 übersteigen muss, vorzugsweise zumindest 4,
der Vorläufer des Elements der Gruppe VI A Selen ist, und
der Vorläufer des Elements der Gruppe II B ein Elementoxid der Gruppe II B ist.

2. Verfahren nach Anspruch 1, wobei die Carboxylsäure eine Alkylcarboxylsäure, vorzugsweise eine Fettsäure, ist.

3. Verfahren nach einem der vorangehenden Ansprüche, wobei das Alken ein C₆-C₁₂-Alken, am meisten bevorzugt 1-Octen, ist.

4. Verfahren nach einem der vorangehenden Ansprüche, wobei der Vorläufer des Elements der Gruppe VI A ein Element der Gruppe VI A ist, vorzugsweise ein Pulver eines Elements der Gruppe VI A.

5. Verfahren nach einem der vorangehenden Ansprüche, wobei das sekundäre Phosphin ein sekundäres Arylphosphin, am meisten bevorzugt Diphenylphosphin, ist.

6. Verfahren nach einem der vorangehenden Ansprüche, wobei die zweite Lösung des Schritts b) zusätzlich ein Lösungsmittel umfasst, vorzugsweise ein Lösungsmittel, das einen Siedepunkt hat, der höher ist als 100°C.

7. Verfahren nach einem der vorangehenden Ansprüche, wobei das Mischen in Schritt c) unter Erhitzen auf eine Temperatur bis zu 50°C durchgeführt wird.

8. Verfahren nach einem der vorangehenden Ansprüche, wobei das Verfahren einen zusätzlichen Aufreinigungsschritt d') umfasst, der dem Schritt d) nachfolgt aber vor einem Schritt e) durchgeführt wird, wobei der zusätzliche Aufreinigungsschritt d'), der dem Schritt d) nachfolgt, vorzugsweise die folgenden Unterschritte umfasst: (i) Kühlen der Lösung, die die II-VI-Halbleiternanokristalle einheitlicher Größe umfasst, auf Raumtemperatur, (ii) Fällen der II-VI-Halbleiternanokristalle einheitlicher Größe durch Zugabe eines Lösungsmittels oder eines Lösungsmittelgemisches, das die Löslichkeit der II-VI-Halbleiternanokristalle in der Lösung, die die II-VI-Halbleiternanokristalle umfasst, herabsetzt, (iii) Zentrifugieren und (iv) Dekantieren, wobei die Schritte (ii) bis (iv) mehrere Male wiederholt werden könnten.

9. Verfahren nach einem der vorangehenden Ansprüche, wobei der Vorläufer des Elements der Gruppe VI A in dem Gemisch der ersten Lösung und der zweiten Lösung in einer Konzentration in einem Bereich von 1 mmol/kg bis 100 mmol/kg, vorzugsweise 10 mmol/kg bis 70 mmol/kg, bezogen auf das gesamte Gewicht der zweiten Lösung, vorliegt.

10. Verfahren nach einem der vorangehenden Ansprüche, wobei das molare Verhältnis des Vorläufers des Elements der Gruppe VI A zu dem sekundären Phosphin in einem Bereich von 1:4 bis 1:2, am meisten bevorzugt 1:1, ist.

## Revendications

1. Méthode de préparation de nanocristaux semiconducteurs II-VI à taille unique comprenant les étapes de :
a) fourniture d'une première solution qui comprend au moins un précurseur d'un élément du groupe II B, au moins un acide carboxylique et au moins un alcène ;
b) fourniture d'une seconde solution qui comprend au moins un précurseur d'un élément du groupe VI A et au moins une phosphine secondaire ;
c) mélange de la première solution et de la seconde solution pour obtenir un mélange réactionnel ; et
d) chauffage du mélange réactionnel pour obtenir une solution contenant des nanocristaux semiconducteurs II-VI à taille unique ;
dans laquelle le rapport molaire acide carboxylique : précurseur d'un élément du groupe II B est de 3 ou moins, de préférence de 2 ou moins ;
le rapport molaire précurseur d'un élément du groupe II B : précurseur d'un élément du groupe VI A doit dépasser 2, de préférence au moins 4,
le précurseur d'un élément du groupe VI A est le sélénium, et
le précurseur d'un élément du groupe II B est un oxyde d'un élément du groupe II B.

2. Méthode selon la revendication 1, dans laquelle l'acide carboxylique est un acide alkylcarboxylique, de préférence un acide gras.

3. Méthode selon l'une quelconque des revendications précédentes, dans laquelle l'alcène est un C₆-C₁₂ alcène, de manière préférée entre toutes le 1-octène.

4. Méthode selon l'une quelconque des revendications précédentes, dans laquelle le précurseur d'un élément du groupe VI A est un élément du groupe VI A, de préférence une poudre d'un élément du groupe VI A.

5. Méthode selon l'une quelconque des revendications précédentes, dans laquelle la phosphine secondaire est une arylphosphine secondaire, de manière préférée entre toutes la diphénylphosphine.

6. Méthode selon l'une quelconque des revendications précédentes, dans laquelle la seconde solution de l'étape b) comprend de plus un solvant, de préférence un solvant ayant un point d'ébullition supérieur à 100°C.

7. Méthode selon l'une quelconque des revendications précédentes, dans laquelle le mélange dans l'étape c) est réalisé sous chauffage à une température allant jusqu'à 50°C.

8. Méthode selon l'une quelconque des revendications précédentes, dans laquelle la méthode comprend une étape de nettoyage supplémentaire d') après l'étape d), mais avant l'étape e), de préférence l'étape de nettoyage supplémentaire d') après l'étape d) comprend les sous-étapes (i) de refroidissement de la solution contenant les nanocristaux semiconducteurs II-VI à taille unique à la température ambiante, (ii) de précipitation des nanocristaux semiconducteurs II-VI à taille unique par addition d'un solvant ou d'un mélange de solvants qui réduit la solubilité des nanocristaux semiconducteurs II-VI à taille unique dans la solution contenant les nanocristaux semiconducteurs II-VI à taille unique, (iii) de centrifugation et (iv) de décantation, dans laquelle les étapes (ii) à (iv) peuvent être répétées plusieurs fois.

9. Méthode selon l'une quelconque des revendications précédentes, dans laquelle la concentration du précurseur d'un élément du groupe VI A dans le mélange de la première solution et de la seconde solution est dans une plage de 1 mmol/kg à 100 mmol/kg, de préférence de 10 mmol/kg à 70 mmol/kg, par rapport au poids total de la seconde solution.

10. Méthode selon l'une quelconque des revendications précédentes, dans laquelle le rapport molaire précurseur d'un élément du groupe VI A : phosphine secondaire est dans une plage de 1:4 à 1:2, de manière préférée entre toutes de 1:1.
